Europäisches Patentamt

European Patent Office

Office européen des brevets

(11) Veröffentlichungsnummer: **0 003 020**
**B1**

(12) **EUROPÄISCHE PATENTSCHRIFT**

(21) Anmeldenummer: **78101476.6**

(22) Anmeldetag: **30.11.78**

(51) Int. Cl.³: **H 01 J 37/34**

(54) Hochfrequenz-Zerstäubungsvorrichtung

(30) Priorität: **30.12.77 US 865812**

(43) Veröffentlichungstag der Anmeldung:
**25.07.79 Patentblatt 79/15**

(45) Bekanntmachung des Hinweises auf die Patenterteilung:
**10.12.80 Patentblatt 80/25**

(84) Benannte Vertragsstaaten:
**DE FR GB**

(56) Entgegenhaltungen:
**US - A - 3 983 022**
**IBM JOURNAL OF RESEARCH AND**
**DEVELOPMENT, Bd 14, (1970),**
**Seiten 172—175**
**New York, USA**
**IBM TECHNICAL DISCLOSURE BULLETIN,**
**Bd. 13, no. 5 (1970), Seite 1296**
**New York, USA**

(73) Patentinhaber: **International Business Machines Corporation**
**Armonk, N.Y. 10504 (US)**

(72) Erfinder: **Bialko, Joseph Alfon**
**11 Oakwood Drive**
**Wappingers Falls NY 12590 (US)**
**Lechaton, John S.**
**Vande Water Drive**
**Wappingers Falls NY 12590 (US)**

(74) Vertreter: **Böhmer, Hans Erich, Dipl.-Ing.**
**Schönaicher Strasse 220**
**D - 7030 Böblingen (DE)**

Courier Press, Leamington Spa, England.

## Hochfrequenz-Zerstäubungsvorrichtung

Die Erfindung betrifft eine Hockfrequenz-Zerstäubungsvorrichtung für das Niederschlagen oder Ablagern von Materialien auf Substraten mit einer an einem Bezugspotential angeschlossenen, Ionisationskammer, einer Prallelektrode, einer auf der Prallelektrode liegenden, aus dielektrischem Material bestehenden Prallplatte, einer Hochfrequenzquelle zur Erzeugung eines Plasmas zwischen der Prallelektrode und der Substratelektrode und mit einer die Substratelektrode teilweise umgebenden Abschirmung.

*Beschreibung des Standes der Technik*

Mit der Entwicklung integrierter Halbleiterschaltungen hat die Zerstäubung von dielektrischen Materialien durch Hockfrequenzfelder zunehmend an Bedeutung gewonnen. Isolierende Schichten aus elektrisch stabilen, hochschmelzenden Materialien lassen sich auf geeignete Halbleitersubstrate durch Hochfrequenzzerstäubung mit besseren Ergebnissen auftragen, als sie mit anderen Verfahren, wie z. B. Verdampfung oder Niederschlag aus der Dampfphase erzielbar sind. Durch Hochfrequenzzerstäubung von Glas kann während des Niederschlags durch das Verfahren der gesteuerten Rückzerstäubung eine Formgebung erzielt werden. Außerdem ist das rückzerstäubte Glas nicht so porös und enthält nicht so viele OH-Moleküle wie die mit anderen Verfahren niedergeschlagenen Gläser.

Bekanntlich hat das Niederschlagen von dünnen Schichten durch Hochfrequenzzerstäubung gegenüber der Gleichspannungszerstäubung Vorteile. Insbesondere kann die Gleichspannungszerstäubung nicht ohne eine Elektronenquelle zur Neutralisierung der Auffangplatte für eine Zerstäubung von Isoliermaterialien benutzt werden. Außerdem kann eine Hochfrequenz-Zerstäubungsvorrichtung zum Einebnen eines aufgestäubten Films entweder während des Niederschlags selbst oder nachdem eine unebene Schicht niedergeschlagen worden ist, benutzt werden.

Das Phänomen der Rückzerstäubung betrifft die Re-Emission eines niedergeschlagenen isolierenden Materials, wie z. B. $SiO_2$ während des eigentlichen Zerstäubungsniederschlags, aufgrund der Wirkungen des gleichzeitigen Ionen-Beschusses der niedergeschlagenen isolierenden Schicht. Die Anwendung des Prinzips der Hochfrequenzzerstäubung auf die Rückzerstäubung ist in einem Aufsatz von R. E. Jones u. a. im Journal of Applied Physics, November 1967, Seite 4656 mit dem Titel "Re-Emission Coefficients of Silicon and Silicon Dioxide Films Deposited through RF and DC Sputtering" beschrieben. Tatsächlich entsteht die Rückzerstäubung einer isolierenden Schicht während des Niederschlags durch einen Beschuß der Schicht mit positiven Ionen.

Im Stand der Technik hat man bereits erkannt, daß die Rückzerstäubung die Qualität der durch Zerstäubung niedergeschlagenen Schicht verbessert, und die US-Patentschrift 3 661 761 offenbart die Verwendung der Hochfrequenzzerstäubung zur Verbesserung der Qualität und Gleichförmigkeit einer Schicht. Die US-Patentschrift 3 983· 022 offenbart die Rückzerstäubung die einer Niederschlagsgeschwindigkeit, die praktisch Null ist zum Einebnen von auf unebenen Oberflächen niedergeschlagenem Schichten.

Während die Rückzerstäubung bei der gewerbsmäßigen Herstellung von integrierten Schaltungen für eine Verbesserung der Qualität der durch Zerstäubung niedergeschlagenen Schicht eingesetzt wurde, war doch das Ausmaß eines solchen Einsatzes für eine vollständige Einebnung wegen der für eine vollständige Einebnung einer über erhabenen Leitungsmustern auf Halbleitersubstraten angebrachten isolierenden Schicht erforderlichen Zeit und aus anderen Gründen beschränkt.

Die in IBM Technical Disclosure Bulletin, September 1971, Seite 1032 von Auyang u. a. beschriebene Zerstäubungsvorrichtung wurde für die Einebnung von dünnen Schichten benutzt. Die Steuerung dieser Vorrichtung, die als gesteuertes System bekannt ist, wird dadurch kompliziert, daß fünf veränderliche Reaktanzen einjustiert werden müssen. Das erfordert den Einsatz eines erfahrenen Technikers, und das hat zur Folge, daß solche Systeme in Großserienfertigung schwierig einzuregeln sind.

Ein anderes bekanntes System für Hochfrequenz-Zerstäubungsniederschlag, das als System mit abgestimmter Anode bezeichnet wird, ist in IBM Journal of Research and Development, Band 14, 1970, Seiten 172—175 durch J. S. Logan mit dem Titel "Control of RF Sputtered Film Properties through Substrate Tuning" beschrieben. In dieser Vorrichtung wird zwischen der isolierten Substratelektrode und einem Bezugspotential, normalerweise Erdpotential, ein abstimmbares L-C-Netzwerk angeordnet.

Auf diese Weise läßt sich der die Substratelektrode durchfließende Hochfrequenzstrom und damit der Betrag der Rückzerstäubung von den daraufliegenden Substraten steuern. Wie Logan bemerkt, ist diese Steuerung der Rückzerstäubung für eine gute Kantenüberdeckung der niedergeschlagenen Schicht an auf den Substraten vorhandenen Stufen erforderlich. Die Menge der Rückzerstäubung ist jedoch beschränkt, und das mit abgestimmter Anode arbeitende System wurde bisher nicht mit Erfolg für die Einebnung einer Oberfläche einer niedergeschlagenen Schicht eingesetzt.

Gewöhnlich wird das System, bevor ein ausreichend hoher Hochfrequenzstrom durch die Substratelektrode, die hier Anode genannt wird, erreicht werden kann, instabil. Dies erkennt man an einem plötzlichen raschen Anstieg des von dem Plasma nach den geerdeten Teilen innerhalb der Apparatus fließenden Hochfrequenzstroms. Dabei gibt es eine entsprechende Abnahme des Anodenstroms. Diese Auswirkung ist in der Veröffentlichung von Logan in Fig. 3 anhand der Gleichvorspannung dargestellt. Am Instabilitätspunkt nimmt die Dichte des Plasmas in der Nähe der Wand der Kammer zu mit einer entsprechenden Abnahme der Impedanz zwischen Plasma und Kammerwand. Dadurch wird der Hochfrequenzstrom nach den Wänden der Kammer umgelenkt, so daß dadurch der auf die Substratelektrode gerichtete Hochfrequenzstrom verringert wird. Ein Verfahren zum Umgehen dieser Schwierigkeit bestand darin, das Verhältnis der Fläche der geerdeten Seitenwand zur Kathodenfläche zu verringern. Dadurch würde auch der Betrag des von der Anode weg nach der Seitenwand umgeleiteten oder abgelenkten Hochfrequenzstroms verringert. Das Ausmaß dieser Lösung ist notwendigerweise auf rein geometrische Betrachtungen begrenzt.

## Gesamtdarstellung der Erfindung

Zur Verbesserung der Konstruktion von Hochfrequenz-Zerstäubungsvorrichtungen für eine Erhöhung der Rückzerstäubungsgeschwindigkeit in solchen Systemen mit der Möglichkeit, eine Einebnung in einem mit einer abgestimmten Anode arbeitenden Systems zu erzielen, wird gemäß der Erfindung vorgeschlagen, die Anodenabschirmung der Hochfrequenz-Zerstäubungsvorrichtung gegen das Bezugspotential zu isolieren. Dadurch werden die am Bezugspotential liegenden Flachen die dem Plasma ausgesetzt sind, verringert, wodurch die Impedanz zwischen Plasma-Anode und den am Bezugspotential liegenden Flachen erhöht wird. Diese Verbesserung hat eine wesentliche Erhöhung der Rückzerstäubungsgeschwindigkeit zur Folge, bevor der Instabilitäts-Arbeitspunkt des Systems erreicht wird.

Durch die erfindungsgemäße Vorrichtung ist man nunmehr in der Lage, normale (nicht ebene) und ebene Glasschichten auf Halbleiterscheiben in dem gleichen, mit einer abgestimmten Anode arbeitenden System lediglich dadurch niederzuschlagen, daß man die Reaktanz des Abstimmnetzwerks verändert.

Diese neuartige Anodenabschirmung ist zudem noch in einzelne Abschnitte unterteilt, läßt sich dadurch leichter reinigen und gestattet eine genauere Ausrichtung des Spaltes zwischen der Abschirmung und der Substratelektrode (Anode).

Die Erfindung wird nunmehr anhand eines bevorzugten Ausführungsbeispiels der Erfindung in Verbindung mit den beigefügten Zeichnungen im einzelnen beschrieben.

In den Zeichnungen zeigt

Fig. 1 eine Querschnittsansicht der bevorzugten Ausführungsform der Zerstäubungsvorrichtung gemäß der Erfindung und

Fig. 2 ein Diagramm des Hochfrequenz-Anodenstroms über der abstimmbaren Substratimpedanz zur Darstellung der durch die Erfindung erzielten Verbesserung.

## Beschreibung der bevorzugten Ausführungsform

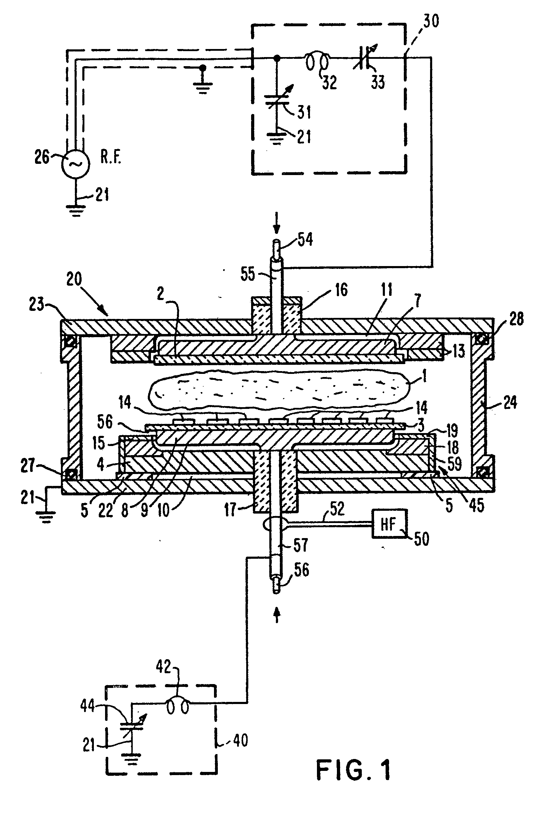

Bevor mit einer Besprechung der in Fig. 1 dargestellten Vorrichtung begonnen werden soll, erscheint eine kurze Übersicht über die Arbeitsweise bei der Hochfrequenzzerstäubung angebracht, um den Rahmen für die Erfindung abzustecken. Bei der Hochfrequenzzerstäubung wird die Prallelektrode, die entweder aus dem niederzuschlagenden Material besteht oder dieses Material trägt, als Kathode bezeichnet. Das Substrat, auf das das von der Prallelektrode kommende Material gerichtet werden soll, wird als Anode bezeichnet. Gegenstände, wie z. B. Halbleiterscheiben, werden zur Aufnahme des Materials der Prallplatte unter dem Einfluß des zwischen diesen beiden Elektroden aufgebauten elektrischen Feldes auf der Anode angeordnet. Wenn das Gas ionisiert wird, werden geladene Gasionen erzeugt, die durch die Kathode angezogen werden. Die Ionen werden in dem Bereich rund um die Kathode, der mit Crookschem Dunkelraum bezeichnet wird, beschleunigt, so daß sie mit einer so hohen Energie auf der Prallplatte aufschlagen, daß atomare Teilchen aus der Prallplatte herausgestoßen werden. Diese zerstäubten Teilchen, also Teilchen des Materials der Prallplatte, werden auf in der Nähe liegende Gegenstände niedergeschlagen. Alle diese Zerstäubungssysteme haben die Aufgabe, daß das zerstäubte Material auf solchen Gegenständen, wie etwa Halbleiterscheiben, die auf der Anode angebracht sind oder auf der Substratelektrode liegen, niedergeschlagen werden.

Hochfrequenzzerstäubung mit Hochfrequenz-Erregung wird im allgemeinen in einem Bereich bei etwa 13,56 bis etwa 40 MHz benutzt, und dies ist der wegen der Vorschriften der Bundeskommunikations-Kommission (FFC) benutzte Bereich. Durch geeignete Auswahl der Frequenz und der Größe der angelegten Spannung kann die Zerstäubungswirkung auf die dielektrische Prallplatte allein beschränkt werden, oder die Zerstäubungswirkung kann auch von den auf der Anode angeordneten Substraten ausgehen, so daß atomare Teilchen von den Substraten durch Rückstreuung ausgehen, wobei dies in ähnlicher Weiser wie bei der Kathodenzerstäubung des von der Kathodenprallplatte ausgehenden Materials der Fall ist.

Bei jedem Zerstäubungsvorgang ist es erwünscht, daß nur das Material der Prallplatte oder bei der Rückzerstäubung nur das Substratmaterial ausgestoßen wird. Es war daher erforderlich, die anderen mit Kathode und Anode verbundenen Teile der Konstruktion gegen die Wirkung eines Ionen-Beschusses zu schützen. Dies hat man normalerweise dadurch erreicht, daß man um die Kathode oder die Anode oder um beide Elektroden herum eine geerdete Abschirmung gelegt hat. Bei einer Hochfrequenzzerstäubung bringt eine derartige Abschirmung auch Nachteile. Wie die Anmelderin festgestellt hat, lenkt eine solche Abschirmung den Strom von der Anode ab.

Die Steuerung oder Regelung der Eigenschaften von durch Hochfrequenzzerstäubung aufgebrachten Schichten einschließlich deren Gleichförmigkeit und Einebnung wird am besten durch das von J. S. Logan beschriebene Verfahren mit der dort gezeigten Vorrichtung erzielt, die durch die vorliegende Erfindung verbessert werden soll. Das von Logan beschriebene System wird allgemein als ein mit abgestimmter Anode arbeitendes System bezeichnet. In diesem System wird die Impedanz zwischen der Substrathalterung oder Anode und einer relativ großen leitenden Oberfläche innerhalb der Zerstäubungskammer in Berührung mit dem Plasma geregelt, wodurch die Größe der Anodenspannung und ihre Phasenlage in bezug auf die Kathodenspannung geregelt wird. Das System enthält ein zwischen Anode und Erde eingeschaltetes Netzwerk mit einer Reihenschaltung von Induktivität und Kapazität, das von einem kapazitiven Blindwiderstand über die Serienresonanz (Blindwiderstand O) bis auf einen induktiven Blindwiderstand verändert werden kann. Das Netzwerk kann dabei so aufgebaut werden, daß es parallel mit der Streukapazität zwischen Anode und Kathode in Resonanz ist, so daß der verbleibende Blindwiderstand zwischen Anode und Masse kontinuierlich von O bis zu einem sehr großen induktiven oder kapazitiven Wert veränderbar ist.

Das von Logan vorgeschlagene abstimmbare Impedanznetzwerk an der Anode ermöglicht eine gewisse Steuerung bei der Zerstäubung von dielektrischen Schichten auf Substraten. Es steuert dabei die relative Hochfrequenzspannung zwischen der Anode und der metallischen Grundplatte, der Deckplatte oder den Seitenwänden der Kammer und der Anodenabschirmung, die alle in dieser aus dem Stand der Technik bekannten Vorrichtung geerdet sind.

Fig. 1 zeigt das neueste Modell eines nach Logan aufgebauten Systems mit abgestimmter Anode, in dem die Erfindung verwirklicht ist. Das System enthält eine Gas unter geringem Druck enthaltende Ionisationskammer 20, die an einem ersten Bezugspotential 21, in diesem Fall Erdpotential angeschlossen ist. Die Ionisationskammer 20 enthält eine metallische Kammerwand 24, die zwischen einem Paar metallischer Grundplatten 22 und 23 angebracht ist. Dichtungsringe 27 und 28 ergeben eine vakummdichte Abdichtung. Die Ionisationskammer 20 besteht im allgemeinen aus Aluminium oder aus rostfreiem Stahl mit einer Aluminiumverkleidung. Ein dafür geeignetes inertes Gas, wie z. B. Argon, wird über einen Einlaß (nicht gezeigt) in die Kammer eingeführt und dort über eine Vakuumpumpe und einen Druckregler auf dem gewünschten, niedrigen Druck gehalten. Innerhalb der gasgefüllten Ionisationskammer ist eine vorzugsweise aus Kupfer bestehende Prallelektrode 7 vorgesehen, auf der eine Scheibe 2 aus dem zu zerstäubenden Material, beispielsweise Siliciumdioxid, angebracht ist. Um die Prallelektrode herum und gegen diese isoliert ist eine zweiteilige Abschirmung 13 aus leitendem Material, beispielsweise Aluminium, angebracht.

In unmittelbarer Beziehung zu dieser Prallelektrode 7 ist eine Substrat-Elektrode 8 vorgesehen, die allgemein als Anode bezeichnet wird. Eine Anodenabschirmung 45 umgibt die Substratelektrode oder Anode 8. Auf der normalerweise aus Kupfer bestehenden Anode ist eine Platte 3 vorgesehen, die Substrate 14 trägt. Im vorliegenden Fall sind die Substrate 14 mit integrierten Schaltungen versehene Halbleiterscheiben, auf deren Oberflächen das von der Prallplatte 2 ausgehende Siliciumdioxid niedergeschlagen werden soll.

Die Substrathalterung 8 ist auf einer isolierenden Stütze 17 befestigt und die Prallelektrode 7 ist auf einer isolierenden Stütze 16 angebracht. Eine Kühlflüssigkeit wird durch Röhren 54 bzw. 56 unter der Substrathalterung 8 und der Prallelektrode 7 hindurchgeleitet.

Ein Hochfrequenzgenerator 26 ist zwischen dem ersten Bezugspotential 21, z. B. Erdpotential, und einer Leitung 55 eingeschaltet, die an der Prallelektrode 7 elektrisch angeschlossen ist. Ein der Impedanzanpassung dienendes Netzwerk 30 ist zwischen Hochfrequenzgenerator 26 und Leitung 55 eingeschaltet. Das Impedanzanpass-Netwerk 30 besteht aus einem Kodensator 31, einer Hochfrequenzspule 32 und einem Kondensator 33. Beide Kondensatoren sind veränderbar, so daß sich daraus ein variables Impedanzanpass-Netzwerk ergibt.

Die Anode 8 ist über eine Leitung 57 und die aus einem veränderbaren Kondensator 44 und einer Hochfrequenzspule 42 bestehende Abstimmschaltung 40 für die Substratelektrode mit dem Bezugspotential 21 verbunden. Obgleich die bevorzugte Ausführungsform diese Systems mit veränderbaren Kondensatoren arbeitet, könnten genauso gut die Spulen 32 und 42 durch veränderbare Induktivitäten ersetzt werden.

Die Impedanzanpass-Schaltung 30 soll während der Zerstäubungsoperation, die nach dem Generator 26 zurückreflektierte Leistung vermindern. Die Abstimmschaltung 40 für die Substratelektrode regelt während der Hochfrequenzzerstäubung das an der Anode 8 liegende Hochfrequenzpotential. Die einstellbare zwischen Anode 8 und Bezugspotential 21 leigende Hochfrequenzimpedanz, die wegen des darüber fließenden Hochfrequenzstroms ein Hochfrequenzpotential erzeugt, bewirkt, daß an der Schichtoberfläche ein genau geregeltes Gleichspannungspotential sich ausbildet.

Wenn der Hochfrequenzgenerator 26 eine ausreichend hohe Leistung liefert, dann wird in dem Raum zwischen der Prallelektrode 7 und der Platte 3 ein Plasma 1 gebildet. Wird die Prallplatte 2 durch die in dem Plasma befindlichen Ionen beschossen, dann werden atomare Teilchen des Prallplattenmaterials durch Zerstäubung herausgelöst und auf den von der Platte 3 auf der Anode 8 getragenen Substraten 14 niedergeschlagen.

Zwischen Anodenabschirmung 45 und Anode 8 ist ein Spalt 9 vorgesehen, der eine übermäßige kapazitive Kopplung der Hochfrequenz verhindert. Dieser Spalt muß jedoch klein genug sein, damit das Plasma nicht auch die Rückseite der Anode 8 angreift. Der Spalt 11 zwischen Prallelektrode 7 und Prallplattenabschirmung 13 hat einen ähnlichen Zweck.

Die bisher beschriebene Vorrichtung ist dem Fachmann aus der Halbleitertechnik und insbesondere den mit dem Niederschlagen dünner Schichten vertrauten Fachmann bekannt. Die vorliegende Erfindung bezieht sich auf die elektrische Beziehung der Anodenabschirmung 45 zum übrigen System und auch auf die mechanische Konstruktion der Abschirmung. Wie bereits angedeutet, ist die Abschirmung 45 bei den bisher bekannten Systemen an dem ersten Bezugspotential 21 angeschlossen. Der offensichtliche Grund dafür ist, daß eine geerdete Abschirmung jede Glimmentladung unterdrückt, die sonst hinter der Substrathalterung 3 in der Nachbarschaft der Anode 8 auftreten könnte. Die Anmelderin hat jedoch festgestellt, daß das System dann unstabil wird, wenn die Hochfrequenzleistung soweit erhöht wird, daß eine Rückzerstäubung des Materials von den Halbleiterscheiben 14 stattfindet, wobei ein plötzlicher Anstieg des Hochfrequenzstroms vom Plasma 1 nach den geerdeten Teilen des System, d. h. der Seitenwand 24 der Kammer 20 und der Anodenabschirmung 45 auftritt. Bringt man jedoch gemäß der Erfindung isolierende Abstandsstücke 5 zwischen der Anodenabschirmung 45 und der geerdeten Grundplatte 22 an, dann läßt sich die Menge der Rückzerstäubung beträchtlich erhöhen, ehe der Punkt der Instabilität erreicht wird. Die isolierenden Abstandsstücke 5 bestehen vorzugsweise aus Polytetrafluoräthylen, obgleich andere Isoliermaterialien dazu verwendet werden könnten. Die Abstandsstücke können dabei die Form eines Ringes haben, der mit der unteren Oberfläche der Abschirmung 45 kongruent ist. Andererseits könnte auch eine Anzahl einzelner Abstandsstücke vorgesehen werden, die die Abschirmung 45 von der Grundplatte 22 auf Abstand halten. Der durch die Abstandsstücke 5 gebildete Spalt beträgt etwa 1,5 mm, obgleich andere Werte, abhängig von den Systemparametern ebenfalls brauchbar sein können.

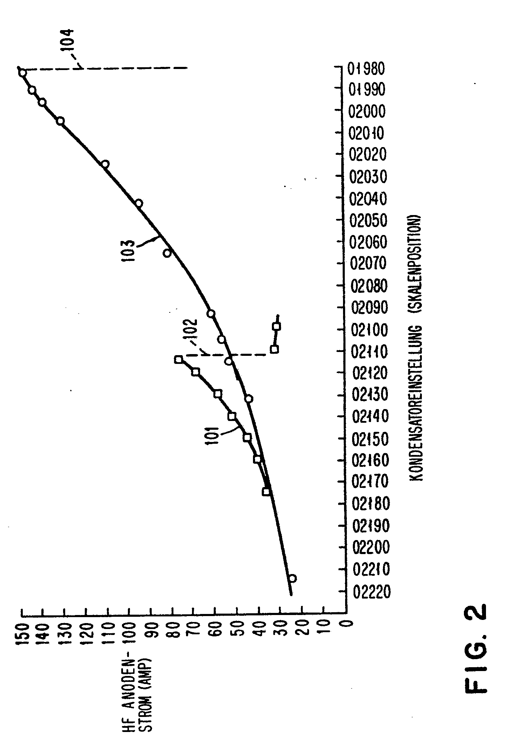

Isoliert man die Anodenabschirmung gegen Erde, dann wird das Plasma 1 dadurch weiter von Erdpotential entfernt, daß man die geerdeten Flächen, denen das Plasma ausgesetzt ist, verringert. Dadurch wird die Impedanz zwischen Plasma und Erde weiter erhöht. Wenn also die vom Plasma 1 nach den geerdeten Flächen in der Kammer 20 gesehene Impedanz zunimmt, dann steigt auch der über die Anode 8 und die Leitung 57 fließende Strom an. Dadurch erhöht sich der Leistungsverbrauch an der Platte 3 durch eine von den Halbleiterscheiben 14 ausgehende Zerstäubung, was hier als Rückzerstäubung bezeichnet wird. Die Zunahme des effektiv durch das System hindurchfließenden Stroms läßt sich leicht durch einen Breitbandübertrager 52 und ein Hochfrequenzspannungs-Meßgerät 50 überwachen. Die Ergebnisse, die sich durch die Erfindung erzielen lassen, werden im einzelnen noch anhand von Fig. 2 besprochen.

In Fig. 2 ist in einem Diagramm der hochfrequente Anodenstrom über der Kondensatoreinstellung des veränderbaren Kondensators 44 im Abstimmnetzwerk 40 in Fig. 1 aufgetragen. Der hochfrequente Anodenstrom wird mit Hilfe des Hochfrequenzspannungs-Meßgerätes 50 und des Breitbandübertragers 52 zwischen Anode 8 und Bezugspotential 21 gemessen.

Eine Abnahme der Kapazität entspricht dabei einer Zunahme des Blindwiderstandes der Anodenimpedanz. Die Kurve für die geerdete Anodenabschirmung ist mit den Bezugszeichen 101 und 102 bezeichnet. Die Kurve für die nicht geerdete Abschirmung ist durch die Bezugszeichen 103 und 104 bezeichnet.

Mit geerdeter Anoden-Abschirmung wird der Instabilitätspunkt bei etwa 75 A erreicht. Dieser Wert liegt unterhalb desjenigen Wertes, der für eine Einebnung notwendig ist. An diesem Punkt fällt der Anodenstrom, wie dies durch die gestrichelte Linie 102 angedeutet ist, praktisch auf etwa 30 A ab. Jenseits dieses Maximalstroms von etwa 75 A ist die Impedanz zwischen Plasma 1 und Erde 21 über die Anode 8 groß und der über diesen Weg fließende Hochfrequenzstrom ist klein. Daher nimmt die Anode 8 ein Potential an, das viel näher an dem des Plasmas liegt und Hochfrequenzstrom wird von der Anode abgeleitet.

Arbeitet man dagegen mit nicht-geerdeter Anodenabschirmung 45, so erzielt man einen Anodenstrom von rund 150 A, wie dies die Kurve 103 zeigt, bevor der Instabilitätspunkt erreicht wird, der durch das Bezugszeichen 104 bezeichnet ist. Ein bis 150 A gehender Strom läßt aber eine Rückzerstäubung des auf Halbleiterscheiben niedergeschlagenen $SiO_2$ zu.

Bei einer Zerstäubungsvorrichtung ähnlich der in Fig. 1 gezeigten wurden Silicium-Scheiben auf eine Glashalterung mit einem Durchmesser von 533 mm aufgebracht. Der Durchmesser der Anode betrug 508 mm. Eine Silicium-Prallplatte mit einem Durchmesser von 520,7 mm war auf einer Kathode mit einem Durchmesser von 508 mm befestigt. Eine Hochfrequenzleistung von etwa 3 kW wurde angelegt. Der Abstand zur Prallplatte betrug etwa 28 ± 1,27 mm.

Der Argon-Druck wirde auf 25 × 10⁻³ Torr gehalten. Verschiedene Versuchsläufe wurden durchgeführt, wobei die Substratreaktanz mit Hilfe der veränderbaren Impedanz 44 verändert wurde. Bei jeder Veränderung wurde der über die Leitung 57 nach der Anode 8 fließende Hochfrequenzstrom gemessen. Die Stromsonde liefert eine Ausgangsspannung, die dem Strom proportional ist.

Eine für eine gute Kantenüberdeckung auf der Halbleiterscheibe 14 ausreichende Rückzerstäubung trat bei 60 A ein,und eine Einebnung wurde bei etwa 90 A erreicht mit einem Re-Emissionskoeffizienten von etwa 0,75. In der Nähe von 150 A näherte sich der Re-Emissionskoeffizient dem Wert 1,0.

Andere Gesichtspunkte der neu konstruierten Abschirmung sollen nun besprochen werden. Wie man aus Fig. 1 erkennt, besteht die Anodenabschirmung aus drei getrennten konzentrischen Abschnitten, nämlich einer Platte 4, einem Abstandsstück 18 und einem Kreisring 19. Kreisring 19 und Abstandsstück 18 sind mit der Platte 4 durch Maschinenschrauben verbunden. Die Platte 4 ist mit der Grundplatte 22 der Kammer 20 durch isolierte Maschinenschrauben (nicht gezeigt) verbunden.

Bekanntlich muß der zwischen Anode 8 und Anodenabschirmung 45 bestehende Spalt genau eingestellt werden. Der Spalt 9 ist, abhängig von anderen Parametern des Systems, zwischen 1,27 mm und 5,08 mm breit. Außerdem muß der Spalt 56 zwischen Platte 3 und Anodenabschirmung 45 exakt eingestellt sein. Wenn die Spalte einmal eingestellt sind, dann gibt es in einem gut durchkonstruierten und aufgebauten System keine Veränderungen der Spaltbreiten. Manchmal ist es jedoch notwendig, den Anodenteil für eine Reinigung oder zum Messen des Spaltes 9 auseinander zu nehmen. In diesem Fall müssen die Spalte beim erneuten Zusammenbau wiederum gemessen und, falls erforderlich, neu eingestellt werden. Der Spalt 9 läßt sich durch Einstellung der Anode 8 in bezug auf das als Platte 4 ausgebildete Abstandsstück einstellen. Dies ist eine komplizierte und langwierige Aufgabe und erfordert oft Versuchsläufe, um zur richtigen Einstellung der Spalte zu gelangen. Dies ist bei den bisher aus einem Stück bestehenden Abschirmungen eine ziemlich umständliche Arbeit. Die nunmehr aus drei Teilen bestehende Abschirmung erleichtert diese Arbeit beträchtlich. Die untere Platte 4 der Abschirmung kann beim Messen des Spaltes 9 dadurch in fester Lage bezüglich der Anode 8 gehalten werden, daß man nur die Abschnitte 18 und 19 entfernt. Wenn lediglich die Bereiche innerhalb des Spaltes 9 gereinigt werden sollen oder der Spalt 56 neu eingestellt werden soll, dann kann nach Abnehmen der Platte 3 der Kreisring 19 entfernt werden, ohne die anderen Teile zu beeinflussen. Durch Abnehmen des Abstandsstückes 18 der Anodenabschirmung läßt sich der Spalt 9 zwischen Elektrode und Abschirmung genau messen, ohne dabei die Platte 4 zu beeinträchtigen, woduch die Einstellung des Spaltes erleichtert wird. Das Abstandsstück 18 ist vorzugsweise ein aus zwei Teilen bestehender Ring und läßt sich damit leichter entfernen.

Eine dünne, zylinder förmige Abschirmung 59 aus Aluminium schützt die Anodenabschirmung gegen zerstäubtes Glas. Wenn das Glas gereinigt werden muß, dann kann die Aluminium-Abschirmung 59, die auf den Abstandstücken 5 ruht, ebenso wie der Kreisring 19 abgenommen werden, ohne daß die anderen Teile der Anodenabschirmung, wie z. B. die Platte 4, beeinträchtigt werden.

**Patentansprüche**

1.    Hochfrequenz-Zerstäubungsvorrichtung mit einer an einem Bezugspotential (21) angeschlossenen Ionisationskammer (20), einer Prallelektrode (7), einer auf der Prallelektrode liegenden, aus dielektrischem Material bestehenden Prallplatte (2), einer Hochfrequenzquelle (26) zur Erzeugung eines Plasmas (1) zwischen der Prallelektrode und einer Substratelektrode (8) und mit einer die Substratelektrode teilweise umgebenden Abschirmung (45), dadurch gekennzeichnet, daß die Abschirmung (45) gegen das Bezugspotential (21) isoliert (5) ist.

2. Zerstäubungsvorrichtung nach Anspruch 1 mit einer elektrischen Isolation zwischen Prallelektrode, Substratelektrode und Bezugspotential, dadurch gekennzeichnet, daß zwischen der Substratelektrode (8) und dem Bezugspotential (21) ein Impedanzglied (40; 42, 44) eingeschaltet ist.

3. Zerstäubungsvorrichtung nach Anspruch 2, dadurch gekennzeichnet, daß die Impedanz des Impedanzgliedes durch eine veränderbare Kapazität (44) einstellbar ist.

4. Zerstäubungsvorrichtung nach Anspruch 1, dadurch gekennzeichnet daß zwischen der Ionisationskammer (20) und der Abschirmung (45) ein isolierendes, vorzugsweise aus Polytetrafluoräthylen bestehendes Abstandsstück (5) vorgesehen ist.

5. Zerstäubungsvorrichtung nach Anspruch 1, dadurch gekennzeichnet, daß das Impedanzglied (40; 42, 44) auf etwa 13,5 MHz abgestimmt ist.

6. Zerstäubungsvorrichtung nach Anspruch 5, dadurch gekennzeichnet, daß das zu zerstäudbende Material ein dielektrisches Material ist.

7. Zerstäubungsvorrichtung nach Anspruch 1, dadurch gekennzeichnet, daß die Substratelektrode (8) kreisförmig ist, daß die einen Abstand von der Substratelektrode (8) aufweisende Abschirmung (45; 4, 5, 18, 19) kreisringförmig fast die ganze Oberfläche der Substratelektrode mit Ausnahme der der Prallelektrode gegenüberliegenden Fläche umgibt und daß dabei die Abschirmung aus einer unter der Substratelektrode (8) liegenden Platte (4), einem rund um die Oberseite dieser Platte liegenden, einen Teil des Randes der Substratelektrode umgebenden Abstandsstück (18) und einem weiteren lösbar auf der Oberseite des Abstandsstückes (18) angebrachten, einen weiteren Teil des Randes der Substratelektrode (8) umgebenden Kreisring (19) besteht, wodurch der Abstand (9) zwischen Abschirmung (45) und Substratelektrode (8) nach Abnehmen des Abstandsstückes (18) und des Kreisringes (19) meßbar wird.

8. Zerstäubungsvorrichtung nach Anspruch 7, dadurch gekennzeichnet, daß eine kreisförmige, als Substrathalterung dienende Platte (3) auf der oberen Oberfläche der Substratelektrode (8) und seitlich über diese hinausragend ist und von dem Kreisring (19) einen Abstand aufweist.

9. Vorrichtung nach Anspruch 8, dadurch gekennzeichnet, daß auf der Substratelektrode (8) bzw. auf der darauf angebrachten Platte (3) mit einem dielektrischen Material zu überziehende Werkstücke (14) angeordnet sind und daß das Impedanzglied (40) auf das gewünschte Maß der von den Werkstücken (14) ausgehenden Rückzerstäubung des dielektrischen Materials einstellbar ist.

**Claims**

1. High-frequency sputtering apparatus including an ionization chamber (20) connected to a reference potential (21), a target electrode (7), a target (2) of dielectric material supported on said target electrode, a high-frequency source (26) for producing a plasma (1) between said target electrode and a substate electrode (8), and a shield means (45) partially enclosing said substrate electrode, characterised in that said shield means (45) is insulated (5) from said reference potential (21).

2. Sputtering apparatus in accordance with claim 1, with an electrical insulation between target electrode, substrate electrode and reference potential, characterized in that an impedance means (40, 42, 44) is connected between substrate electrode (8) and reference potential (21).

3. Sputtering apparatus in accordance with claim 2, characterized in that the impedance of the impedance means is adjustable by a variable capacitance (44).

4. Sputtering apparatus in accordance with claim 1, characterized in that an insulating spacer (5), preferably consisting of polytetrafluoroethylene, is provided between the ionization chamber (20) and the shield means (45).

5. Sputtering apparatus in accordance with claim 1, characterized in that the impedance means (40; 42, 44) is tuned to about 13.5 MHz.

6. Sputtering apparatus in accordance with claim 5, characterized in that the material to be sputtered is a dielectric material.

7. Sputtering apparatus in accordance with claim 1, characterized in that the substrate electrode (8) is annular, that the shield means (45; 4, 5, 18, 19) spaced from said substrate electrode (8) annularly surrounds substantially all but the surface of said substrate electrode which faces said target electrode, and that said shield means is made up of a plate (4) disposed beneath said substrate electrode (8), a spacer (18) disposed around the top side of said plate, surrounding a portion of the side surface of said substrate electrode, and a further ring (19) removably mounted atop said spacer (18) surrounding another portion of the side surface of said substrate electrode (8), whereby measurement of the spacing (9) between shield means (45) and substrate electrode (8) may be made by removal of said spacer (18) and said ring (19).

8. Sputtering apparatus in accordance with claim 7, characterized in that an annular plate (3) serving as a substrate holder is disposed atop and overhanging the upper surface of said substrate electrode (8), said substrate holder being spaced from said ring (19).

9. Apparatus in accordance with claim 8, characterized in that workpieces (14) to be coated with dielectric material are arranged on the substrate electrode (8) and on the plate (3) mounted thereon, respectively, and that the impedance means (40) may be adjusted to control the rate of resputtering of said dielectric material from said workpieces (14).

**Revendications**

1. Dispositif de pulvérisation à haute fréquence comportant une chambre d'ionisation (20) reliée à un potentiel de réféfence (21), une électrode de cible (7), une cible en matériau diélectrique (2) supportée sur cette électrode de cible, une source de haute fréquence (26) pour produire un plasma (1) entre l'électrode de cible et une électrode de substrat (8), et un écran (45) entourant partiellement l'électrode de substrat, caractérisé en cu que: cet écran (45) est isolé (5) de ce potentiel de référence (21).

2. Dispositif de pulvérisation selon la revendication 1, ayant une isolation électrique entre l'électrode de cible, l'électrode de substrat et le potentiel de référence, caractérisé en ce que: un élément d'impédance (40; 42, 44) est connecté entre l'électrode de substrat (8) et le potentiel de référence (21).

3. Dispositif de pulvérisation selon la revendication 2, caractérisé en ce que l'impédance de l'élément d'impédance est ajustable à l'aide d'un condensateur variable (44).

4. Dispositif de pulvérisation selon la revendication 1, caractérisé en ce qu'une pièce d'espacement isolante (5), de préférence composée de polytétrafluoroéthylène, est prévue entre la chamber d'ionisation (20) et l'écran (45).

5. Dispositif de pulvérisation selon la revendication 1, caractérisé en ce que l'élément d'impédance (40; 42, 44) est accordé à environ 13,5 MHz.

6. Dispositif de pulvérisation selon la revendication 5, caractérisé en ce que le matériau à pulvériser est un matériau diélectrique.

7. Dispositif de pulvérisation selon la revendication 1, caractérisé en ce que l'électrode de substrat (8) est circulaire, que l'écran (45; 4, 5, 18, 19) qui est espacé de l'électrode de substrat (8) entoure, en forme de couronne, presque toute la surface de l'électrode de substrat à l'exception de la surface opposée à l'électrode de cible, et que l'écran est composé d'une plaque (4) située en-dessous de l'électrode de substrat (8), d'une pièce d'espacement (18) ronde autour de la face supérieure de cette plaque, entourant une partie du bord de l'éctrode de substrat, et d'un autre anneau circulaire (19) monté de façon détachable sur la face supérieure de la pièce d'espacement (18) et entourant une autre partie du bord de l'électrode de substrat (8), ce qui permet de mesurer l'espacement (9) entre l'écran (45) et l'électrode de substrat (8) après avoir enlevé la pièce d'espacement (18) et l'anneau circulaire (19).

8. Dispositif de pulvérisation selon la revendication 7, caractérisé en ce qu'une plaque circulaire (3) servant de support de substrat est montée sur la face supérieure de l'électrode de substrat (8) dépassant celle-ci latéralement, et est espacée de l'anneau circulaire (19).

9. Dispositif de pulvérisation selon la revendication 8, caractérisé en ce que des pièces à traiter (14) devant être recouvertes avec un matériau diélectrique sont rangées sur l'éctrode de substrat (8) ou sur la plaque (3) montée dessus, et que l'élément d'impédance (40) est réglable de sorte à obtenir le taux désiré de repulvérisation du matériau diélectrique à partir des pièces à traiter (14).

FIG. 1

FIG. 2